# FASCICULE DE BREVET EUROPEEN

(11) **EP 3 210 092 B1**
(45) Date de publication et mention de la délivrance du brevet: **24.02.2021**
(21) Numéro de dépôt: 15781673.7
(22) Date de dépôt: 19.10.2015
(51) Int. Cl.: G06F 1/18, G11B 33/08, G11B 33/12, H05K 7/14

(54) **ENSEMBLE DE FIXATION ET DE RACCORDEMENT D'UN DISPOSITIF DE STOCKAGE DE DONNÉES INFORMATIQUES À UN CALCULATEUR EMBARQUÉ ET PROCÉDÉ D'UTILISATION ASSOCIÉ**
BEFESTIGUNGS- UND VERBINDUNGSANORDNUNG EINES DATENSPEICHERGERÄTS AN EINEM EINGEBETTETEN COMPUTERSYSTEM UND DAZUGEHÖRIGES ANWENDUNGSVERFAHREN
FASTENING AND CONNECTING ASSEMBLY OF A DATA STORAGE DEVICE TO AN EMBEDDED COMPUTING SYSTEM AND CORRESPONDING METHOD

(30) Priorité: 21.10.2014 FR 1402361
(43) Date de publication de la demande: 30.08.2017
(73) Titulaire: Thales, 92400 Courbevoie (FR)
(72) Inventeur: FEYRIN, Georges, F-33608 Pessac Cedex (FR); ABOMNES, Pascal, F-33187 Le Haillan (FR); DUPUIS, Nicolas, F-33608 Pessac Cedex (FR); MEYRE, Nicolas, F-33187 Le Haillan (FR)
(74) Mandataire: Lavoix
(86) Numéro de dépôt international: PCT/EP2015/074166
(87) Numéro de publication internationale: WO 2016/062670

(56) Documents cités:
- WO-A1-97/13188
- US-A- 6 061 232
- US-A1- 2004 032 711
- US-A1- 2010 259 849
- US-B1- 7 190 575

## Description

La présente invention concerne un ensemble de fixation et de raccordement d'un dispositif de stockage de données informatiques à un calculateur embarqué.

Les calculateurs embarqués sont souvent amenés à fonctionner dans des environnements sévères présentant un certain nombre de contraintes, notamment de nature mécanique. Ceci est particulièrement le cas des calculateurs embarqués dans des aéronefs.

De manière générale, ces calculateurs sont adaptés pour subir des vibrations, des facteurs de charges élevées ou bien d'autres types de contraintes. Ces contraintes sont par ailleurs imposées à tout le périphérique utilisable avec ces calculateurs, comme par exemple des dispositifs de stockage de données informatiques.

Dans le domaine aéronautique, il est connu d'utiliser des dispositifs de stockage spécialement conçus pour supporter les contraintes mécaniques imposées par un environnement de fonctionnement sévère.

Ces dispositifs de stockage sont par exemple des cartes mémoires n'ayant pas de partie mécanique mobile. L'absence de partie mécanique mobile permet à ces dispositifs de stockage de résister mieux aux contraintes mécaniques. La lecture de ces cartes mémoires s'effectue via des dispositifs de lectures adaptés.

Cependant, ces dispositifs de stockage et de lecture sont spécifiques et ne sont pas des composants couramment accessibles et généralement appelés « composants pris sur étagère » (COTS, de l'anglais « Commercial Off-The-Shelf »). En particulier, ceci rend difficile l'utilisation des dispositifs de stockage avec des calculateurs au sol qui ne sont pas équipés de dispositifs de lecture adaptés.

Ainsi, par exemple, on connait des dispositifs de stockages et des moyens de fixations associés tels qui sont décrits dans US 2004/032711 A1 ou dans US 6 061 232 A.

Il existe également un autre type de dispositifs de stockage utilisables dans le domaine aéronautique et présentant des disques durs aptes à fonctionner dans des environnements sévères, qui sont munis d'une protection mécanique adaptée. Cette protection permet d'amortir les vibrations des dispositifs de stockage et de garder une connexion constante avec le calculateur embarqué. Ceci rend alors possible l'utilisation des dispositifs de stockage de type COTS dans les environnements sévères.

Toutefois, ces dispositifs de stockage munis d'une protection se présentent souvent sous la forme de composants informatiques encombrants et déportés du calculateur embarqué, et ne permettent généralement pas d'extraire rapidement le dispositif de stockage pour l'utiliser avec d'autres calculateurs, notamment des calculateurs au sol.

Un des buts de l'invention est de proposer un ensemble de fixation et de raccordement supportant l'utilisation des dispositifs de stockage de type COTS dans des environnements sévères tout en restant compact et simple d'utilisation.

À cet effet, la présente invention a pour objet un ensemble de fixation conforme à la revendication 1.

Suivant d'autres aspects avantageux de l'invention, l'ensemble de fixation et de raccordement comprend une ou plusieurs des caractéristiques définies par les revendications dépendantes, prise(s) isolément ou suivant toutes les combinaisons techniquement possibles.

La présente invention concerne également un procédé d'utilisation d'un tel ensemble de fixation et de raccordement, le procédé étant conforme à la revendication 13.

Les caractéristiques et avantages de l'invention apparaîtront à la lecture de la description qui va suivre, donnée uniquement à titre d'exemple non limitatif, et faite en référence aux dessins annexés, sur lesquels :
- la figure 1 est une vue en perspective d'un ensemble de fixation et de raccordement selon l'invention, l'ensemble comportant une structure d'encapsulation et une structure d'accueil, la structure d'encapsulation étant insérée dans la structure d'accueil ;
- la figure 2 est une vue en perspective de l'ensemble de la figure 1 monté dans un calculateur embarqué ;
- la figure 3 est une vue en perspective de la structure d'encapsulation de la figure 1 ;
- la figure 4 est une vue en perspective de la structure d'encapsulation de la figure 1 selon un autre angle de vue ; et
- la figure 5 est vue en perspective de la structure d'accueil de la figure 1.

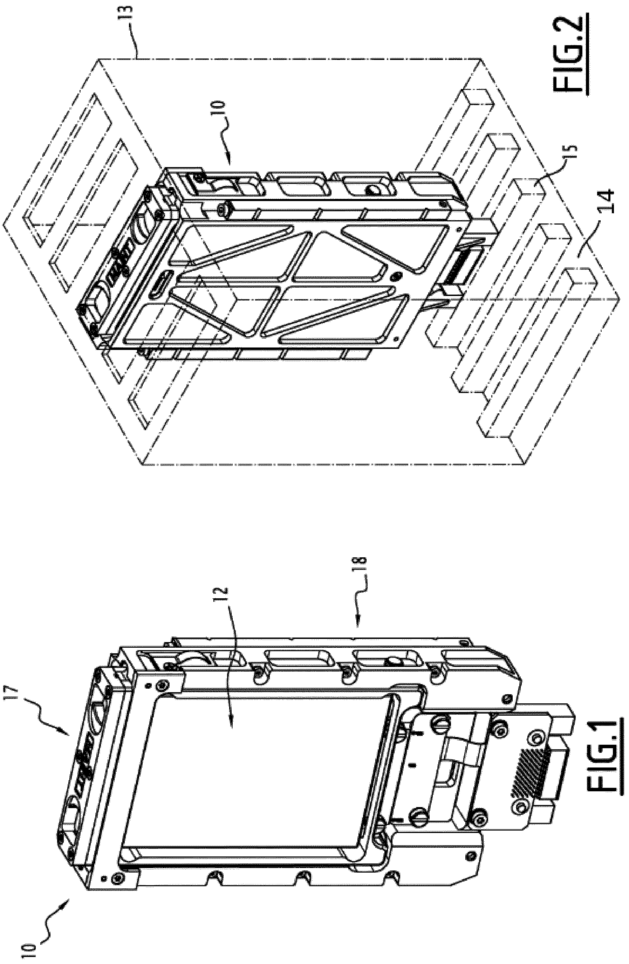

Un ensemble 10 de fixation et de raccordement d'un dispositif 12 de stockage de données informatiques est représenté sur la figure 1.

Le dispositif de stockage 12 est par exemple un disque dur de type SSD (de l'anglais « Solid State Drive ») connu en soi. Ce dispositif fait également partie des moyens informatiques couramment accessibles et autrement appelés « composants pris sur étagère » ou COTS (de l'anglais « Commercial Off-The-Shelf »).

Le dispositif de stockage 12 se présente par exemple sous la forme d'un boitier parallélépipédique allongé, de largeur 3,5", ayant quatre faces latérales, une face proximale et une face distale. Les faces distale et proximale sont perpendiculaires à chacune des faces latérales.

Le dispositif de stockage 12 comprend un connecteur de raccordement disposé sur sa face distale et compatible par exemple avec l'interface électrique SATA avec un connecteur du type NSS (de l'anglais « No Scratch Sata ») ou de tout autre type dérivé de ce type.

Le dispositif de stockage 12 comprend en outre des moyens de fixation permettant de le fixer sur un support adapté. Ces moyens de fixation comprennent par exemple des trous de fixation disposés sur la partie périphérique de l'une de ses faces latérales.

L'ensemble 10 permet de raccorder et de fixer le dispositif de stockage 12 à un calculateur embarqué fonctionnant dans un environnement sévère tel que par exemple l'environnement de fonctionnement d'un aéronef ou de tout autre véhicule aérien, terrestre ou spatial. Cet environnement présente un certain nombre de contraintes comme par exemple des chocs mécaniques et/ou des vibrations et/ou des facteurs de charge importants.

Le calculateur embarqué comprend une pluralité de modules informatiques regroupés dans un boiter 13 illustré sur la figure 2. Ce boitier 13 comporte en outre un fond de panier 14 fixé sur une surface de fixation de ce boitier et comprenant une pluralité de connecteurs de raccordement permettant de raccorder les différents modules informatiques entre eux.

Plus particulièrement, le fond de panier 14 comporte au moins un connecteur de raccordement compatible avec la surface de raccordement du type CompactPCI 3U. Un tel connecteur est visible sur la figure 2 sur laquelle il est désigné par la référence 15.

Le boitier 13 comporte en outre une ouverture sur une surface opposée à la surface de fixation en regard de chaque connecteur. Cette ouverture permet notamment d'extraire ou d'insérer différents modules informatiques de ou dans le boitier 13.

En référence à la figure 1, l'ensemble de fixation et de raccordement 10 comporte une structure 17 d'encapsulation apte à recevoir le dispositif de stockage 12 de manière amovible et une structure 18 d'accueil apte à recevoir la structure d'encapsulation 17 de manière amovible et à être fixée dans le boitier 13 du calculateur embarqué pour raccorder le dispositif de stockage 12 au calculateur embarqué.

Ainsi, la structure d'encapsulation 17 et le dispositif de stockage 12 monté dans celle-ci sont mobiles dans la structure d'accueil 18 entre une configuration insérée dans laquelle le dispositif de stockage 12 est raccordé au connecteur de raccordement 15 du fond de panier 14, et une configuration extraite dans laquelle la structure d'encapsulation 17 et le dispositif de stockage 12 sont extraits hors de la structure d'accueil 18 et en particulier, hors du boitier 13.

Sur les figures 1 et 2, la structure d'encapsulation 17 est insérée dans la structure d'accueil 18.

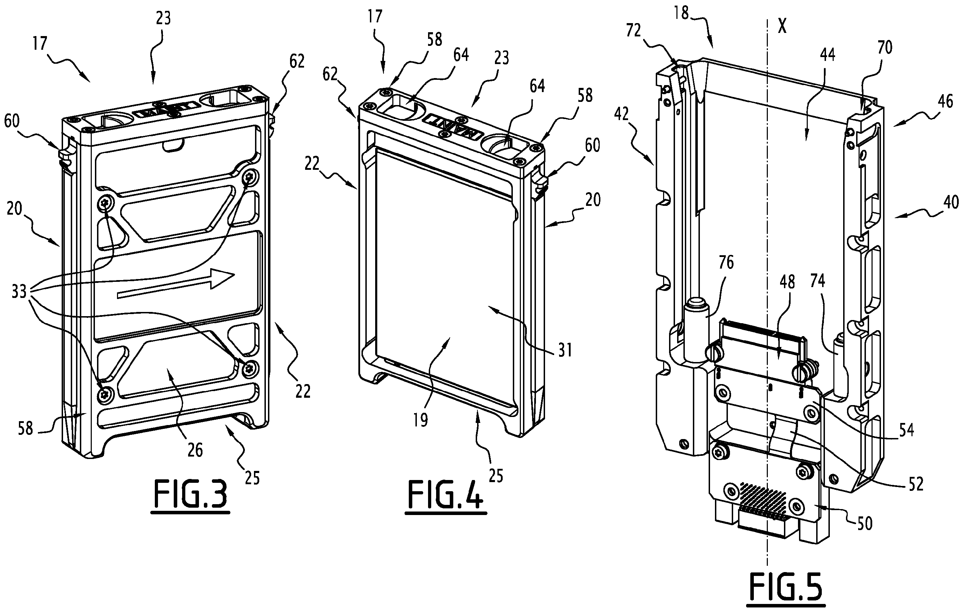

La structure d'encapsulation 17 est illustrée plus en détail sur les figures 3 et 4 sur lesquelles elle est extraite de la structure d'accueil 18.

En référence à ces figures, la structure d'encapsulation 17 forme un cadre périphérique fait par exemple à partir d'un matériau métallique et délimitant un espace de réception 19. Le cadre périphérique est formé de deux parois latérales 20 et 22, d'une paroi proximale 23, d'une paroi distale 25 et d'une paroi de fond 26 fermant le cadre. Les parois proximale et distale sont perpendiculaires aux deux parois latérales 20 et 22 et à la paroi de fond 26.

Le cadre périphérique a ainsi une forme parallélépipédique de dimensions supérieures à celles du dispositif de stockage 12 et définit une fenêtre 31 d'insertion du dispositif de stockage 12 à l'opposé de la paroi de fond 26.

La fenêtre d'insertion 31 est visible sur la figure 4 et permet d'insérer le dispositif de stockage 12 de sorte que la face latérale du dispositif de stockage 12 comportant les trous de fixation, est plaquée sur la paroi de fond 26 de la structure d'encapsulation 17, et que la face distale du dispositif de stockage 12 vient en contact avec la paroi distale 25 de la structure d'encapsulation 17.

La paroi de fond 26 de la structure d'encapsulation 17 comporte des moyens 33 de fixation du dispositif de stockage 12 dans la structure d'encapsulation 17, aptes à coopérer avec les moyens de fixation du dispositif de stockage 12.

Sur la figure 3, ces moyens de fixation 33 se présentent sous la forme d'orifices de passage disposés en regard des trous de fixation du dispositif de stockage 12 et des vis de taille adaptée pour être vissées dans les trous de fixation à travers les orifices de passage.

En outre, la paroi distale 25 de la structure d'encapsulation 17 définit un orifice de passage pour le connecteur du type NSS de raccordement du dispositif de stockage 12.

La structure d'accueil 18 est représentée plus en détail sur la figure 5. Sur cette figure, la structure d'encapsulation 17 est extraite de la structure d'accueil 18.

De manière analogue à la structure d'encapsulation 17, la structure d'accueil 18 comporte deux parois latérales 40 et 42 parallèles l'une à l'autre et s'étendant suivant un axe d'insertion X. Ces parois latérales 40 et 42 délimitent entre elles un espace 44 de réception de la structure d'encapsulation 17.

La structure d'accueil 18 comporte en outre une paroi de fond 46 s'étendant transversalement entre les deux parois latérales 40 et 42.

La structure d'accueil 18 a une forme allongée selon l'axe d'insertion X entre une extrémité distale apte à venir en contact avec le fond de panier 14 et une extrémité proximale opposée à l'extrémité distale.

La structure d'accueil 18 forme un module informatique standard du calculateur embarqué qui est apte à être fixé dans le boitier 13 via l'ouverture correspondante et en utilisant des moyens de fixation prévus à cet effet.

L'espace de réception 44 définit une partie distale adjacente à l'extrémité distale de la structure d'accueil et une partie proximale opposée à la partie distale.

La structure d'accueil 18 comporte en outre une entretoise présentant par exemple une barre rigide transversale entre les deux parois latérale 40 et 42 disposée dans l'extrémité proximale de la structure d'accueil 18 du côté opposé à celui de la paroi de fond 46.

La structure d'accueil 18 comporte en outre un premier connecteur 48 complémentaire du connecteur de raccordement du dispositif de stockage 12 et un deuxième connecteur 50 complémentaire du connecteur de raccordement 15 du fond de panier 14. Le premier connecteur 48 est notamment compatible avec l'interface électrique SATA avec un connecteur du type NSS complémentaire du connecteur de raccordement du dispositif de stockage 12. Le deuxième connecteur 50 est notamment compatible avec la surface de raccordement du type CompactPCI 3U et complémentaire au connecteur de raccordement du fond de panier 14. Bien entendu, d'autres interfaces et/ou connecteurs de raccordement peuvent être envisagés.

Les deux connecteurs 48 et 50 sont déplaçables axialement l'un par rapport à l'autre et reliés entre eux par une liaison de communication 52 flexible. Cette liaison permet de raccorder le connecteur du dispositif de stockage 12 au connecteur 15 du fond de panier 14.

Le deuxième connecteur 50 est disposé dans l'extrémité distale de la structure d'accueil 18 et fait saillie par rapport à la structure d'accueil 18 pour coopérer avec le connecteur 15 du fond de panier. En outre, le deuxième connecteur 50 est fixé par rapport à la structure d'accueil 18.

Le premier connecteur 48 est monté sur un chariot 54 mobile en translation par rapport à la structure d'accueil 18 selon l'axe d'insertion X. Ce premier connecteur 48 est disposé dans la partie distale de l'espace de réception 44 pour coopérer avec le connecteur du dispositif de stockage 12 du fait de l'insertion de la structure d'encapsulation 17 dans l'espace de réception 44.

La structure d'encapsulation 17 est apte à être insérée dans l'espace de réception 44 selon l'axe d'insertion X via l'extrémité proximale de la structure d'accueil 18.

Lors de cette insertion, les parois latérales 20, 22 de la structure d'encapsulation 17 sont destinées à entrer en contact avec respectivement les parois latérales 40, 42 de la structure d'accueil 18.

Lorsque la structure d'encapsulation 17 est insérée dans la structure d'accueil, la paroi proximale 23 de la structure d'encapsulation 17 fait saillie par rapport à la structure d'accueil 18 et au boitier 13.

La structure d'encapsulation 17 comporte par ailleurs un dispositif 58 de détrompage mécanique permettant d'insérer la structure d'encapsulation 17 dans la structure d'accueil 18 uniquement de façon décrite ci-dessus.

Ce dispositif de détrompage 58 se présente par exemple sous la forme de deux chanfreins situés de chaque côté de la paroi de fond 26 de la structure d'encapsulation 17.

En outre, les parois latérales 40 et 42 de la structure d'accueil 18 permettent de guider la structure d'encapsulation 17 lors de son insertion ou de son extraction.

À cet effet, les parois latérales 20 et 22 de la structure d'encapsulation 17 comportent chacune une glissière faisant saillie par rapport à la paroi correspondante, et les parois latérales 40 et 42 de la structure d'accueil définissent chacune une forme sensiblement complémentaire à la glissière correspondante pour recevoir cette glissière.

La structure d'encapsulation 17 comporte en outre un dispositif de verrouillage permettant de la verrouiller dans la structure d'accueil 18.

Le dispositif de verrouillage se présente par exemple sous la forme de deux verrous 60 et 62 disposés respectivement sur les parois latérales 20 et 22 du dispositif d'encapsulation 17 à la proximité de la paroi proximale 23. Ces verrous sont visibles sur les figures 3 et 4.

En variante, le dispositif de verrouillage se présente sous la forme d'un verrou disposé sur l'une des parois latérales 20 et 22 du dispositif d'encapsulation 17 à la proximité de la paroi proximale 23.

Bien entendu, d'autres formes du dispositif de verrouillage sont également possibles.

Les verrous 60 et 62 sont actionnables par un utilisateur à partir d'un organe 64 d'actionnement disposé sur la paroi proximale 23 de la structure d'encapsulation 17.

Cet organe 64 permet de passer les verrous 60 et 62 d'une position verrouillée de repos dans laquelle ils font saillie par rapport aux parois latérales 20 et 22 à une position déverrouillée dans laquelle ils sont reçus dans la partie intérieure de la paroi proximale 23.

La structure d'accueil 18 comporte deux butées 70 et 72 de verrouillage disposées respectivement sur les parois latérales 40 et 42 de la structure d'accueil 18 pour coopérer respectivement avec les verrous 60 et 62 lorsque la structure d'encapsulation 17 est insérée dans la structure d'accueil 18.

L'organe d'actionnement 64 présente une forme ergonomique adaptée pour permettre à l'utilisateur d'actionner le déverrouillage avec deux doigts.

En outre, l'organe d'actionnement 64 comporte un dispositif de retour permettant aux verrous 60 et 62 de revenir de la position déverrouillée actionnée par l'utilisateur à la position verrouillée lorsque l'utilisateur n'exerce plus d'action sur l'organe 64.

La structure d'accueil 18 comporte en outre deux poussoirs 74 et 76 disposés dans la partie distale de l'espace de réception 44. Ces poussoirs sont visibles sur la figure 5.

Les poussoirs 74 et 76 permettent d'éjecter au moins en partie la structure d'encapsulation 17 hors de la structure d'accueil 18 et en particulier, hors du boitier 13, facilitant ainsi la préhension par les côtés de la structure d'encapsulation 17.

Plus particulièrement, poussée par les poussoirs 74 et 76, une partie de la structure d'encapsulation 17 est apte à s'extraire de la structure d'accueil 18. Dans l'état extrait, cette partie fait saillie par rapport à la structure d'accueil 18 par exemple de 12 mm. Ceci permet alors à l'utilisateur de saisir la structure d'encapsulation 17 avec les doigts en la tenant par les parties extraites des parois latérales 20 et 22.

Les poussoirs 74 et 76 présentent par exemple deux ressorts venant en appui sur la paroi distale 25 de la structure d'encapsulation 17. Lorsque la structure d'encapsulation 17 est verrouillée, les ressorts sont contraints du fait de l'insertion de la structure d'encapsulation 17 dans la structure d'accueil 18. Lorsque la structure d'encapsulation 17 est déverrouillée, les ressorts sont libérés et poussent la structure d'encapsulation 17 hors de la structure d'accueil 18.

Finalement, la structure d'accueil 18 comporte un dispositif d'amortissement latéral (non-représenté) permettant d'amortir les déplacements de la structure d'encapsulation selon une direction perpendiculaire à l'axe d'insertion X.

Un procédé d'utilisation de l'ensemble de fixation et de raccordement selon l'invention va maintenant être décrit.

Initialement, l'ensemble de fixation et de raccordement 10 et le dispositif de stockage 12 sont fournis. La structure d'encapsulation 17 est extraite de la structure d'accueil 18.

Une première étape consiste à fixer le dispositif de stockage 12 dans la structure d'encapsulation 17 en utilisant les moyens de fixation décrits précédemment. Ainsi, la structure d'encapsulation 17 et le dispositif de stockage 18 monté dans celle-ci, forment un composant unique apte à être transporté ou utilisé avec des calculateurs au sol de type COTS de manière indépendante de la structure d'accueil 18.

Une étape suivante consiste à fixer la structure d'accueil 18 dans le boiter 13 du calculateur embarqué afin de raccorder le deuxième connecteur 50 au connecteur 15 du fond de panier 14.

Une étape suivante consiste à insérer la structure d'encapsulation 17 et le dispositif de stockage 12 monté dans celle-ci, dans la structure d'accueil 18. Pour ceci, l'utilisateur appuie sur la paroi proximale 23 de structure d'encapsulation 17 selon l'axe d'insertion X pour vaincre la pression des poussoirs 74, 76 et du chariot 54, et passer les verrous 60 et 62 respectivement dans les butées de verrouillage 70 et 72.

La structure d'encapsulation 17 est ainsi verrouillée dans la structure d'accueil 18 et le connecteur du dispositif de stockage 12 est raccordé au premier connecteur 48 de la structure d'accueil 18.

Pour extraire la structure d'encapsulation 17, l'utilisateur actionne l'organe d'actionnement 64 pour déverrouiller la structure d'encapsulation 17 et les poussoirs 74 et 76 l'éjectent hors de la structure d'accueil 18.

Ainsi, l'utilisation de l'ensemble de fixation et de raccordement est particulièrement simple.

Le dispositif de verrouillage et les poussoirs permettent à l'utilisateur d'insérer et d'extraire la structure d'encapsulation de manière rapide et simple.

De plus, le premier connecteur mobile, la liaison flexible entre le premier connecteur et le deuxième connecteur, le dispositif d'amortissement latéral et le dispositif de verrouillage permettent au dispositif de stockage de fonctionner dans des environnements sévères et contraignants et assurent une bonne connectivité avec le calculateur embarqué.

L'ensemble selon invention permet en outre d'utiliser un dispositif de stockage de type SSD qui est accessible au grand public et apte à fonctionner avec la plus part de calculateurs existants.

Finalement, l'ensemble selon l'invention est particulièrement ergonomique et compact. Il permet d'utiliser le dispositif de stockage comme un simple module informatique connecté au fond de panier du calculateur embarqué tout en laissant une possibilité de son extraction rapide et simple.

Il est à noter que le dispositif de verrouillage de la structure d'encapsulation comporte un nombre minimal de pièces. En particulier, selon l'exemple de réalisation décrit, le dispositif de verrouillage comportant deux verrous et un organe d'actionnement.

Ceci garantit en particulier la robustesse du dispositif de verrouillage.

## Revendications

1. Ensemble (10) de fixation et de raccordement d'un dispositif (12) de stockage de données informatiques à un calculateur embarqué, le dispositif de stockage (12) et le calculateur embarqué comportant chacun un connecteur de raccordement, l'ensemble de fixation (10) comportant :
- une structure (17) d'encapsulation définissant un espace (19) de réception du dispositif de stockage (12) et comprenant des moyens (33) de fixation du dispositif de stockage (12) dans cet espace de réception (19) ; et
- une structure (18) d'accueil définissant un espace (44) de réception permettant d'y insérer la structure d'encapsulation (17) et comprenant un premier connecteur (48) complémentaire du connecteur du dispositif de stockage et un deuxième connecteur (50) complémentaire du connecteur (15) du calculateur embarqué ;
dans lequel la structure d'encapsulation (17) et le dispositif de stockage (12) monté dans celle-ci sont mobiles par rapport à la structure d'accueil (18) entre une configuration insérée dans laquelle la structure d'encapsulation (17) et le dispositif de stockage (12) sont insérés dans la structure d'accueil (18) et le connecteur du dispositif de stockage (12) est raccordé au premier connecteur (48), et une configuration extraite dans laquelle la structure d'encapsulation (17) et le dispositif de stockage (12) sont extraits hors de la structure d'accueil (18) et le connecteur du dispositif de stockage (12) est déconnecté du premier connecteur (48) ;
dans lequel la structure d'accueil (18) comporte une liaison (52) de communication flexible reliant le premier connecteur (48) et le deuxième connecteur (50), l'un des connecteurs (48 ; 50) étant mobile par rapport à l'autre ;
dans lequel le deuxième connecteur (50) est disposé dans l'extrémité distale de la structure d'accueil (18) et est fixé par rapport à la structure d'accueil (18) ;
dans lequel le premier connecteur (48) est disposé dans une partie distale de l'espace de réception (44) de la structure d'accueil (18) pour coopérer avec le connecteur du dispositif de stockage (12) du fait de l'insertion de la structure d'encapsulation (17) dans l'espace de réception (44), et
dans lequel le premier connecteur (48) est monté sur un chariot (54) mobile en translation par rapport à la structure d'accueil (18) selon un axe (X) d'insertion.

2. Ensemble (10) selon la revendication 1, dans lequel la structure d'encapsulation (17) comprend deux parois (20 ; 22) latérales parallèles délimitant entre elles l'espace de réception (19), chaque paroi latérale (20 ; 22) comportant une glissière pour guider la structure d'encapsulation (17) lors de son insertion ou de son extraction dans ou de la structure d'accueil (18).

3. Ensemble (10) selon la revendication 2, dans lequel la structure d'encapsulation (17) comporte en outre une paroi (23) proximale perpendiculaire aux parois latérales (20 ; 22) et accessible depuis l'extérieur de la structure d'accueil (18) lorsque la structure d'encapsulation (17) est insérée dans la structure d'accueil (18).

4. Ensemble (10) selon la revendication 3, dans lequel :
- la structure d'encapsulation (17) comprend un dispositif de verrouillage comportant au moins un verrou (60 ; 62) et un organe (64) d'actionnement actionnable depuis la paroi proximale (23) pour passer la structure d'encapsulation (17) d'une position verrouillée dans la structure d'accueil (18) à une position déverrouillée ; et
- la structure d'accueil (18) comprend une butée (70 ; 72) de verrouillage pour le ou chaque verrou (60 ; 62).

5. Ensemble (10) selon la revendication 4, dans lequel l'organe d'actionnement (64) présente une forme ergonomique adaptée pour permettre à un utilisateur d'actionner le déverrouillage avec deux doigts.

6. Ensemble (10) selon la revendication 4 ou 5, dans lequel l'organe d'actionnement (64) comporte un dispositif de retour permettant au ou à chaque verrou (60 ; 62) de revenir de la position déverrouillée actionnée par un utilisateur à la position verrouillée lorsque l'utilisateur n'exerce plus d'action sur l'organe (64).

7. Ensemble (10) selon l'une quelconque des revendications précédentes, dans lequel la structure d'accueil (18) comporte au moins un poussoir (74 ; 76) de la structure d'encapsulation (17) dans le sens de son extraction de la structure d'accueil (18) lorsque la structure d'encapsulation (17) est insérée dans la structure d'accueil (18).

8. Ensemble (10) selon la revendication 7, dans lequel le ou chaque poussoir (74 ; 76) permet d'éjecter au moins en partie la structure d'encapsulation (17) hors de la structure d'accueil (18).

9. Ensemble (10) selon l'une quelconque des revendications précédentes, dans lequel la structure d'accueil (18) comporte un dispositif d'amortissement latéral permettant d'amortir les déplacements de la structure d'encapsulation (17) selon une direction perpendiculaire à l'axe (X) d'insertion de la structure d'encapsulation (17) dans la structure d'accueil (18).

10. Ensemble (10) selon l'une quelconque des revendications précédentes, dans lequel la structure d'encapsulation (17) comporte un dispositif (58) de détrompage mécanique permettant d'insérer la structure d'encapsulation (17) dans la structure d'accueil (18) de manière unique.

11. Ensemble (10) selon l'une quelconque des revendications précédentes, dans lequel le premier connecteur (48) est compatible avec l'interface du type SATA.

12. Ensemble (10) selon l'une quelconque des revendications précédentes, dans lequel le deuxième connecteur (50) est compatible avec l'interface du type CompactPCI 3U.

13. Procédé d'utilisation d'un ensemble (10) de fixation et de raccordement selon l'une quelconque des revendications précédentes, **caractérisé en ce qu'**il comprend les étapes suivantes :
- la fixation du dispositif de stockage (12) dans la structure d'encapsulation (17) par les moyens de fixation (33) ;
- le raccordement du deuxième connecteur (50) de la structure d'accueil (18) au connecteur de raccordement (15) du calculateur embarqué ;
- l'insertion de la structure d'encapsulation (17) avec le dispositif de stockage (12) monté, dans la structure d'accueil (18) ; et
- l'extraction de la structure d'encapsulation (17) avec le dispositif de stockage (12) monté hors de la structure d'accueil (18).

## Patentansprüche

1. Einrichtung (10) zur Befestigung und zum Anschluss einer Vorrichtung (12) zur Speicherung von Computerdaten an einem bordeigenen Rechner, wobei die Vorrichtung zur Speicherung (12) und der bordeigene Rechner jeweils einen Anschlussverbinder aufweisen, wobei die Einrichtung zur Befestigung (10) aufweist:
- eine Struktur (17) zur Einkapselung, die einen Raum (19) zur Aufnahme der Vorrichtung zur Speicherung (12) definiert und die Mittel (33) zur Befestigung der Vorrichtung zur Speicherung (12) in diesem Raum zur Aufnahme (19) aufweist, und
- eine Struktur (18) zur Aufnahme, die einen Raum (44) zur Aufnahme definiert, der es ermöglich, die Struktur zur Einkapselung (17) dort hinein einzusetzen, und der einen ersten Verbinder (48), der zu dem Verbinder der Vorrichtung zur Speicherung komplementär ist, und einen zweiten Verbinder (50) aufweist, der zu dem Verbinder (15) des bordeigenen Rechners komplementär ist,
wobei die Struktur zur Einkapselung (17) und die Vorrichtung zur Speicherung (12), die in diese montiert ist, bezüglich der Struktur zur Aufnahme (18) bewegbar sind zwischen einer eingesetzt-Konfiguration, in welcher die Struktur zur Einkapselung (17) und die Vorrichtung zur Speicherung (12) in die Struktur zur Aufnahme (18) eingesetzt sind und der Verbinder der Vorrichtung zur Speicherung (12) an den ersten Verbinder (48) angeschlossen ist, und einer herausgenommen-Konfiguration, in welcher die Struktur zur Einkapselung (17) und die Vorrichtung zur Speicherung (12) aus der Struktur zur Aufnahme (18) herausgenommen sind und der Verbinder der Vorrichtung zur Speicherung (12) von dem ersten Verbinder (48) abgekuppelt ist,
wobei die Struktur zur Aufnahme (18) eine flexible Verbindung (52) zur Kommunikation aufweist, die den ersten Verbinder (48) und den zweiten Verbinder (50) verbindet, wobei einer der Verbinder (48; 50) bezüglich des anderen bewegbar ist,
wobei der zweite Verbinder (50) am distalen Ende der Struktur zur Aufnahme (18) angeordnet ist und bezüglich der Struktur zur Aufnahme (18) fixiert ist,
wobei der erste Verbinder (48) an einem distalen Abschnitt des Raums zur Aufnahme (44) der Struktur zur Aufnahme (18) angeordnet ist zum Zusammenwirken mit dem Verbinder der Vorrichtung zur Speicherung (12) aufgrund des Einsetzens der Struktur zur Einkapselung (17) in den Raum zur Aufnahme (44), und wobei der erste Verbinder (48) an einen Schlitten (54) montiert ist, der entlang einer Einsetz-Achse (X) translationsbewegbar ist bezüglich der Struktur zur Aufnahme (18) .

2. Einrichtung (10) gemäß Anspruch 1, wobei die Struktur zur Einkapselung (17) zwei laterale, parallele Wände (20; 22) aufweist, die zwischen sich einen Aufnahmeraum (19) begrenzen, wobei jede laterale Wand (20; 22) eine Geradführung aufweist zum Führen der Struktur zur Einkapselung (17) während deren Einsetzens oder deren Herausnehmens in die oder aus der Struktur zur Aufnahme (18).

3. Einrichtung (10) gemäß Anspruch 2, wobei die Struktur zur Einkapselung (17) ferner aufweist eine proximale Wand (23), die zu den lateralen Wänden (20; 22) senkrecht ist und vom Äußeren der Struktur zur Aufnahme (18) her zugänglich ist, wenn die Struktur zur Einkapselung (17) in die Struktur zur Aufnahme (18) eingesetzt ist.

4. Einrichtung (10) gemäß Anspruch 3, wobei:
- die Struktur zur Einkapselung (17) aufweist eine Vorrichtung zur Verriegelung, die aufweist wenigstens einen Riegel (60; 62) und ein Organ (64) zur Betätigung, welches betätigbar ist von der proximalen Wand (23) aus zum Verbringen der Struktur zur Einkapselung (17) von einer verriegelt-Position in der Struktur zur Aufnahme (18) zu einer entriegelt-Position, und wobei
- die Struktur zur Aufnahme (18) einen Anschlag (70; 72) zur Verrieglung für den oder jeden Riegel (60; 62) aufweist.

5. Einrichtung (10) gemäß Anspruch 4, wobei das Organ zur Betätigung (64) eine ergonomische Form hat, die angepasst ist, um es einem Benutzer zur erlauben, das Entriegeln mit zwei Fingern zu bewerkstelligen.

6. Einrichtung (10) gemäß Anspruch 4 oder 5, wobei das Organ zur Betätigung (64) eine Vorrichtung zur Rückführung aufweist, die es dem oder jedem Riegel (60; 62) ermöglicht, von der entriegelt-Position aus, die von einem Benutzer bewerkstelligt ist, in die verriegelt-Position zurückzukehren, wenn der Benutzer das Organ (64) nicht mehr betätigt.

7. Einrichtung (10) gemäß irgendeinem der vorhergehenden Ansprüche, wobei die Struktur zur Aufnahme (18) aufweist wenigstens einen Schiebebetätiger (74; 76) der Struktur zur Einkapselung (17) in Richtung deren Herausnahme aus der Struktur zur Aufnahme (18), wenn die Struktur zur Einkapselung (17) in die Struktur zur Aufnahme (18) eingesetzt ist.

8. Einrichtung (10) gemäß Anspruch 7, wobei der oder jeder Schiebebetätiger (74; 76) es ermöglich, die Struktur zur Einkapselung (17) wenigstens teilweise aus der Struktur zur Aufnahme (18) auszuschieben.

9. Einrichtung (10) gemäß irgendeinem der vorhergehenden Ansprüche, wobei die Struktur zur Aufnahme (18) aufweist eine Vorrichtung zur seitlichen Dämpfung, die es ermöglicht, die Verlagerungen der Struktur zur Einkapselung (17) entlang einer Richtung senkrecht zur Achse (X) des Einsetzens der Struktur zur Einkapselung (17) in die Struktur zur Aufnahme (18) zu dämpfen.

10. Einrichtung (10) gemäß irgendeinem der vorhergehenden Ansprüche, wobei die Struktur zur Einkapselung (17) eine mechanische Vorrichtung (58) zur Verwechslungssicherung aufweist, die es ermöglich, die Struktur zur Einkapselung (17) in einer einzigen Weise in die Struktur zur Aufnahme (18) einzusetzen.

11. Einrichtung (10) gemäß irgendeinem der vorhergehenden Ansprüche, wobei der erste Verbinder (48) kompatibel ist mit der Schnittstelle des Typs SATA.

12. Einrichtung (10) gemäß irgendeinem der vorhergehenden Ansprüche, wobei der zweite Verbinder (50) kompatibel ist mit der Schnittstelle des Typs ComapctPCI 3U.

13. Verfahren zur Verwendung einer Einrichtung (10) zur Befestigung und zum Anschluss gemäß irgendeinem der vorhergehenden Ansprüche, **dadurch gekennzeichnet, dass** es die folgenden Schritte aufweist:
- das Befestigen der Vorrichtung zur Speicherung (12) in der Struktur zur Einkapselung (17) mittels der Mittel zur Befestigung (33),
- das Anschließen des zweiten Verbinders (50) der Struktur zur Aufnahme (18) an den Verbinder zum Anschluss (15) des bordeigenen Rechners,
- das Einsetzen der Struktur zur Einkapselung (17) mit der montierten Vorrichtung zur Speicherung (12) in die Struktur zur Aufnahme (18), und
- das Herausnehmen der Struktur zur Einkapselung (17) mit der montierten Vorrichtung zur Speicherung (12) aus der Struktur zur Aufnahme (18).

## Claims

1. An assembly (10) for attaching and connecting a computer data storage device (12) to an on-board computer, the storage device (12) and the on-board computer each including a connector, the attaching assembly (10) including:
- an encapsulation structure (17) defining a space (19) for receiving the storage device (12) and comprising means (33) for attaching the storage device (12) in this receiving space (19); and
- a receiving structure (18) defining a receiving space (44) making it possible to insert the encapsulation structure (17) therein and comprising a first connector (48) complementary to the connector of the storage device and a second connector (50) complementary to the connector (15) of the onboard computer;
wherein the encapsulation structure (17) and the storage device (12) mounted therein are movable relative to the receiving structure (18) between an inserted configuration in which the encapsulation structure (17) and the storage device (12) are inserted into the receiving structure (18) and the connector of the storage device (12) is connected to the first connector (48), and a removed configuration in which the encapsulation structure (17) and the storage device (12) are removed from the receiving structure (18) and the connector of the storage device (12) is disconnected from the first connector (48);
wherein the receiving structure (18) includes a flexible communication link (52) connecting the first connector (48) and the second connector (50), one of the connectors (48; 50) being movable relative to the other;
wherein the second connector (50) is disposed in the distal end of the receiving structure (18) and is fixed relative to the receiving structure (18);
wherein the first connector (48) is positioned in a distal part of the receiving space (44) of the receiving structure (18) to cooperate with the connector of the storage device (12) due to the insertion of the encapsulation structure (17) into the receiving space (44), and
wherein the first connector (48) is mounted on a carriage (54) movable in translation relative to the receiving structure (18) along an insertion axis (X).

2. The assembly (10) according to claim 1, wherein the encapsulation structure (17) comprises two parallel side walls (20; 22) defining the receiving space (19) between them, each side wall (20; 22) including a guideway to guide the encapsulation structure (17) during its insertion in or removal from the receiving structure (18).

3. The assembly (10) according to claim 2, wherein the encapsulation structure (17) further includes a proximal wall (23) perpendicular to the side walls (20; 22) and accessible from the outside of the receiving structure (18) when the encapsulation structure (17) is inserted into the receiving structure (18).

4. The assembly (10) according to claim 3, wherein:
- the encapsulation structure (17) comprises a locking device including at least one bolt (60; 62) and an actuating member (64) able to be actuated from the proximal wall (23) to take the encapsulation structure (17) from a position locked in the receiving structure (18) to an unlocked position; and
- the receiving structure (18) comprises a locking stop (70; 72) for the or each bolt (60; 62).

5. The assembly (10) according to claim 4, wherein the actuating member (64) has an ergonomic shape suitable for allowing a user to actuate the unlocking with two fingers.

6. The assembly (10) according to claim 4 or 5, wherein the actuating member (64) includes a return device allowing the or each bolts (60; 62) to return from the unlocked position actuated by a user to the locked position when the user no longer exerts action on the member (64).

7. The assembly (10) according to any one of the preceding claims, wherein the receiving structure (18) includes at least one pusher (74; 76) pushing the encapsulation structure (17) in the direction of its removal from the receiving structure (18) when the encapsulation structure (17) is inserted into the receiving structure (18).

8. The assembly (10) according to claim 7, wherein the or each pusher (74; 76) makes it possible to at least partially eject the encapsulation structure (17) from the receiving structure (18).

9. The assembly (10) according to any one of the preceding claims, wherein the receiving structure (18) includes a side damping device making it possible to damp the movements of the encapsulation structure (17) in a direction perpendicular to an insertion axis (X) of the encapsulation structure (17) into the receiving structure (18).

10. The assembly (10) according to any one of the preceding claims, wherein the encapsulation structure (17) includes a mechanical mistake-proofing device (58) making it possible to insert the encapsulation structure (17) into the receiving structure (18) in a single manner.

11. The assembly (10) according to any one of the preceding claims, wherein the first connector (48) is compatible with the SATA-type interface.

12. The assembly (10) according to any one of the preceding claims, wherein the second connector (50) is compatible with the CompactPCI 3U-type interface.

13. A method for using an attaching and connecting assembly (10) according to any one of the preceding claims, **characterized in that** it comprises the following steps:
- attaching the storage device (12) in the encapsulation structure (17) via the attaching means (33);
- connecting the second connector (50) of the receiving structure (18) to the connector (15) for connecting the on-board computer;
- inserting the encapsulation structure (17) with the storage device (12) mounted, into the receiving structure (18); and
- removing the encapsulation structure (17) with the storage device (12) mounted, from the receiving structure (18).
